Europäisches Patentamt

European Patent Office

Office européen des brevets

(11) Publication number: **0 257 574**
**A2**

# (12) EUROPEAN PATENT APPLICATION

(21) Application number: **87112135.6**

(22) Date of filing: **21.08.87**

(51) Int. Cl.4: **G03C 1/00**

(30) Priority: **29.08.86 JP 133320/86**
**19.12.86 JP 196618/86**

(43) Date of publication of application:
**02.03.88 Bulletin 88/09**

(84) Designated Contracting States:
**DE FR GB**

(71) Applicant: **BROTHER KOGYO KABUSHIKI KAISHA**
**35, 9-chome, Horita-dori Mizuho-ku**
**Nagoya-shi, Aichi-ken(JP)**

(72) Inventor: **Kenji, Sakakibara**
**32, Yashiki, Sachihara**
**Ichinomiya-City(JP)**
Inventor: **Masashi, Ueda**
**3-27, Shimosakacho**
**Mizuho-ku, Nagoya(JP)**

(74) Representative: **Patentanwälte Ruff und Beier**
**Neckarstrasse 50**
**D-7000 Stuttgart 1(DE)**

(54) **Photo/pressure sensitive sheet exposing apparatus.**

(57) Disclosed is an exposing apparatus which comprises a sheet mount for mounting a photo/pressure sensitive sheet thereon for making the photo/pressure sensitive sheet subject to exposure, an exposure light source for exposing the photo/pressure sensitive sheet mounted on the sheet mount from a side opposite to the sheet mount, and a high reflectivity means provided on a mounting surface of the sheet mount. Preferably, the high reflectivity means is formed of a reflector plate finished to have a mirror surface and attached on the mounting surface, or, alternatively, the high reflectivity means is formed by making a mounting surface of the sheet mount be of a white surface.

EP 0 257 574 A2

## PHOTO/PRESSURE SENSITIVE SHEET EXPOSING APPARATUS

### BACKGROUND OF THE INVENTION

#### 1. Field of the Invention

The present invention generally relates to a machine such as an optical printer, a copying machine, etc., using a photo-and pressure-sensitive (hereinafter referred to as "photo/pressure sensitive") sheet as a recording medium, and particularly relates to an exposing apparatus for forming an optical latent image on the photo/pressure sensitive sheet in such a machine.

#### 2. Description of Prior Art

As disclosed, for example, in Japanese Patent Unexamined Publication No. 58-23025/1983, No. 58-88739/1983, etc., known is a photo/pressure sensitive sheet suitable as copying paper etc. in which microcapsules each containing a dye-precursor, photo-setting resin, a photo-sensitizer, a photo polymerization initiator, etc., are applied onto a surface of the photo/pressure sensitive sheet together with a developer which will cause a development reaction in cooperation with the dye-precursor in the microcapsules. In the above-mentioned photo/pressure sensitive sheet, microcapsules are hardened by light at the irradiated surface of the photo/pressure sensitive sheet and are kept not-hardened at the non-irradiated surface of the same sheet. Therefore, if the photo/pressure sensitive sheet is succeedingly pressed by pressing rollers, the not-hardened microcapsules on the surface of the photo/pressure sensitive sheet are broken by pressure so that a development reaction is caused between the dye-precursor and the developer, thereby obtaining a desired copied picture. Accordingly, when such a photo/pressure sensitive sheet is used as copying paper, there is such an advantage that it is possible to obtain a copied material of high picture quality superior in resolution as well as in clearness. There is a further advantage that maintenance is easy because it is not necessary to use toner powder which has been used in a conventional machine using general paper. Such a photo/pressure sensitive sheet is of the so-called self-coloring type. Other than such a photo/pressure sensitive sheet of the self-coloring type, on the other hand, there has been developed a photo/pressure sensitive sheet of the transfer type. The photo/pressure sensitive sheet of the transfer type is arranged such that only such microcapsules as described above are applied onto the photo/pressure sensitive sheet with no developer applied thereon, and a transfer sheet carrying a developer applied thereto is separately prepared. If such a transfer sheet is put on a photo/pressure sensitive sheet of the transfer type which has been subject to exposure processing and then the stack of sheets are pressed, an image is developed on the transfer sheet. In this case, it is possible to obtain the same advantages as those in the photo/pressure sensitive sheet of the self-coloring type.

In either case where the photo/pressure sensitive sheet is of the self-coloring type or of the transfer type, the exposing sensitivity is very poor in exposure processing. Therefore, there have been disadvantages that it takes a long time for exposure so as to lower the copying efficiency and so as to increase the power consumption.

For example, a copying machine is arranged such that an original mounted on an original mount of transparent glass is moved together with the original mount in one direction while the surface of the original is scanned by light from an exposure light source, the surface of a photo/pressure sensitive sheet which is being conveyed is irradiated with the scanning light so that the photo/pressure sensitive sheet is exposed, and then the photo/pressure sensitive sheet is developed by a pressure-fixing device. In that case, since it is necessary to carry out the exposure processing with the photo/pressure sensitive sheet kept horizontally, generally, a sheet mount for mounting the photo/pressure sensitive sheet thereon is provided so that the photo/pressure sensitive sheet is slidably moved on the sheet mount.

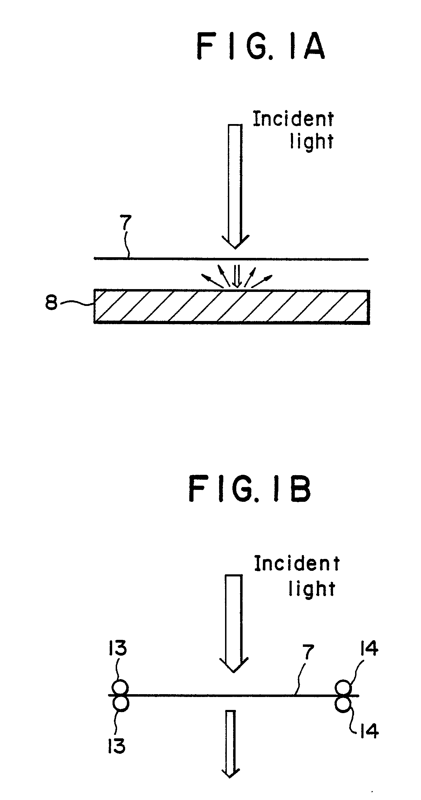

Fig. 1A shows an arrangement in which a photo/pressure sensitive sheet 7 is exposed while being conveyed on a sheet mount 8. In the arrangement, the light incident on the photo/pressure sensitive sheet 7 is transmitted through the photo/pressure sensitive sheet 7, and the transmitted light is reflected on the surface of the sheet mount 8 so that the reflected light is transmitted through the photo/pressure sensitive sheet 7 again so as to expose the photo/pressure sensitive sheet 7. Accordingly, if the surface of the sheet mount 8 is rough, the light is irregularly reflected on the surface of the sheet mount 8 as illustrated in Fig. 1A so as to make an optical latent image have an unclear profile on the photo/pressure sensitive sheet 7, resulting in deterioration in resolution of the image.

In another arrangement illustrated in Fig. 1B, the photo/pressure sensitive sheet 7 is being subject to exposure processing in a state in which the photo/pressure sensitive sheet 7 is supported at its opposite end portions by pinch roller pairs 13, 13 and 14, 14 without using the above-mentioned sheet mount 8. In this case, the photo/pressure sensitive sheet 7 is not exposed from its lower surface with light transmitted through the photo/pressure sensitive sheet, so that unclearness in profile of an optical latent image on the photo/pressure sensitive sheet 7 can be avoided. In this case, however, it is necessary to keep the exposure light source sufficiently large in its light quantity because the light transmitted through the photo/pressure sensitive sheet cannot contribute to the exposure on the photo/pressure sensitive sheet, so that the power consumption is very large.

## SUMMARY OF THE INVENTION

It is therefore an object of the present invention to eliminate the above-mentioned disadvantages in the prior art.

It is another object of the present invention to attain clear picture formation on a photo/pressure sensitive sheet, and to utilize the quantity of light of an exposure light source effectively so as to reduce the quantity of light.

It is a further object of the present invention to make the exposure speed high in a printing apparatus using such a photo/pressure sensitive sheet of the type described above to thereby improve the printing efficiency as well as to utilize the exposure energy effectively to thereby improve the economical property.

In order to achieve the above-mentioned objects, according to an aspect of the present invention, the exposing apparatus comprises a sheet mount for mounting a photo/pressure sensitive sheet thereon for making the photo/pressure sensitive sheet subject to exposure, an exposure light source for exposing the photo/pressure sensitive sheet mounted on the sheet mount from a side opposite to the sheet mount, and a high reflectivity means provided on a mounting surface of the sheet mount.

Preferably, the high reflectivity means is formed of a reflector plate finished to have a mirror surface and attached on the mounting surface.

Alternatively, preferably, the high reflectivity means is formed by making a mounting surface of the sheet mount be of a white surface.

In the thus arranged exposing apparatus according to the present invention, light incident onto the photo/pressure sensitive sheet from the exposure light source is transmitted through the photo/pressure sensitive sheet and then reflected on the high reflectivity surface of the sheet mount so as to surely go back along the optical path where the light had passed. Accordingly, the photo/pressure sensitive sheet is exposed from both the upper and lower surfaces thereof within an area of profile of an expected optical latent image so that desired exposure can be carried out in a short time and an optical latent image having a clear profile can be obtained.

## BRIEF DESCRIPTION OF THE DRAWINGS

Other objects and advantages of the present invention will become apparent during the following discussion of the accompa nying drawings, wherein:

Fig. 1A and Fig. 1B are cross sections for explaining main portions of the prior art;

Fig. 2 is a schematic view showing a structure of a copying machine to which the present invention is applied;

Fig. 3 is a cross section showing a main portion of an embodiment of the present invention;

Fig. 4 is a cross section showing a main portion of another embodiment of the present invention;

Figs. 5 and 6 are views in which the present invention is applied to other exposing means.

## DESCRIPTION OF PREFERRED EMBODIMENTS

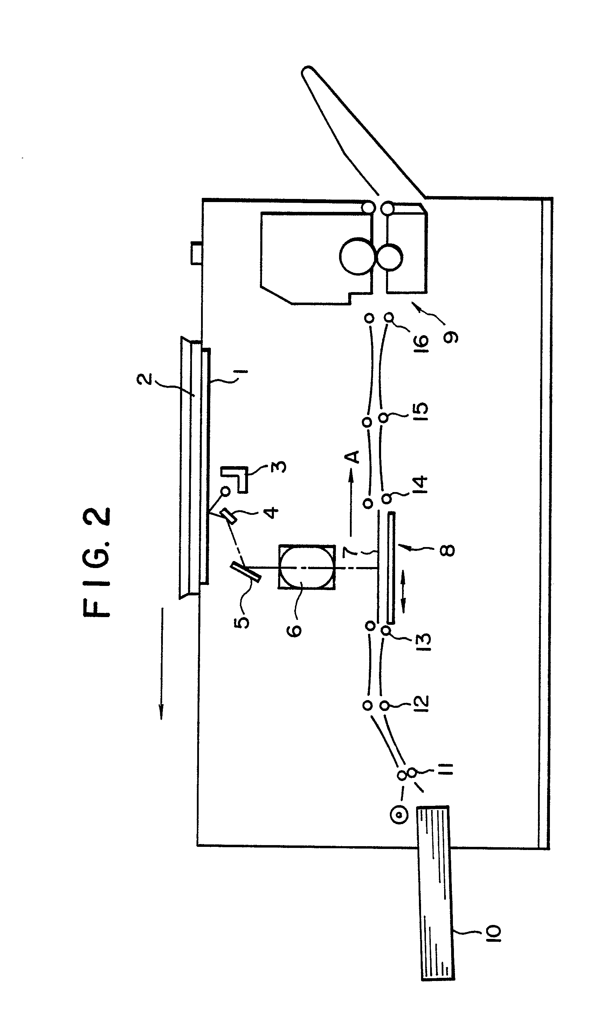

Fig.2 is a schematic view showing a structure of a copying machine to which the present invention is applied. The copying machine is arranged such that an original 2 is put on a horizontally disposed transparent-glass original mount 1, and when scanning light is emitted toward the original 2 from an exposure light source 3 disposed just below the original mount 1, the scanning light is focused on an upper surface of a photo/pressure sensitive sheet 7, which is being conveyed at a predetermined speed in the direction of an arrow A illustrated in Fig. 2, through reflection mirrors 4 and 5, and a focusing lens 6. Further, a reversible sheet mount 8 for supporting and conveying the photo/pressure sensitive sheet 7 is disposed on a coveying line of the photo/pressure sheet 7. The photo/pressure sensitive sheet 7 is guided from a sheet stack 10 to the sheet mount 8 through a pair of rollers 11, a pair of rollers 12, and a pair of rollers 13. The photo/pressure sensitive sheet 7 is subject to predetermined exposure processing on the sheet mount 8, and then pressure-developed by a pressure-developing device 9 disposed at a forwarding end of the photo/pressure sensitive sheet conveying line.

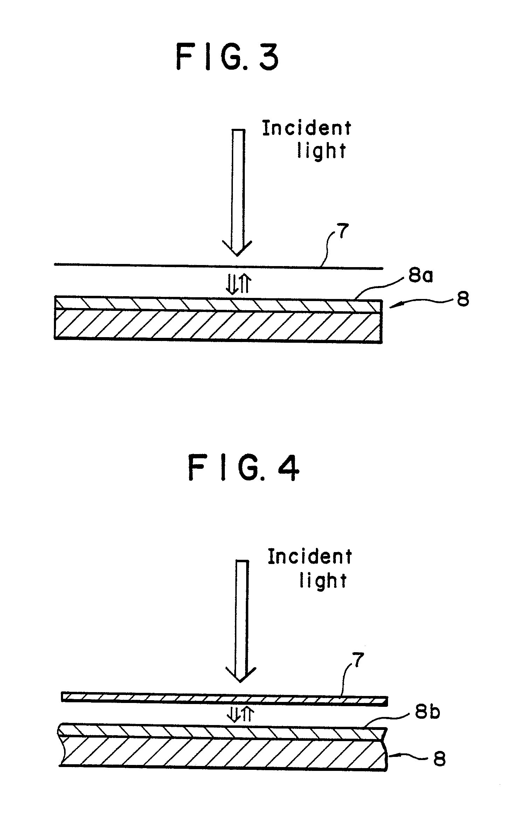

Fig. 3 shows an embodiment of the present invention, in which a reflector plate 8a polished to have a mirror surface as a high reflectivity means is attached on a mounting surface of a sheet mount 8 on which a photo/pressure sensitive sheet 7 is to be mounted. The reflector plate 8a may be a metal plate of such as aluminum, stainless steel, or the like, having a surface finished into a mirror surface by grinding, a metal plate having a metal plated surface, a metal plate having a surface laminated with aluminum foil, or the like. In the thus arranged exposing apparatus, if light is made to be vertically incident onto the sheet mounting surface of the sheet mount 8 when the photo/pressure sensitive sheet 7 is conveyed onto the sheet mount 8, the light is transmitted through the photo/pressure sensitive sheet 7, and then reflected on the sheet mount 8 to go back along the optical path where the light had passed so as to be transmitted through the photo/pressure sensitive sheet 7 again. Therefore, the photo/pressure sensitive sheet 7 is exposed within a profile area of an expected optical latent image by light from both the upper and lower surface sides of the sheet 7. Strictly, in an actual case, a displacement may occur between the area exposed from the upper surface side and the area exposed from the lower surface side by the time difference of conveying the photo/pressure sensitive sheet 7. However, since light advances at an extremely high speed, the displacement can be ignored, and therefore, not only the profile of the optical latent image is not made unclear but the reflected light contributes effectively to exposure of the photo/pressure sensitive sheet 7 to make the exposure.

The present invention is not limited to the case of application to a copying machine, but it is applicable to a not-shown optical printer or the like in which the photo/pressure sensitive sheet is used as an optically writing recording medium.

Fig. 4 shows a main portion of another embodiment. In the drawing, a mirror surface or a metal plated surface is formed as a high reflectivity means on a surface 8b of a sheet mount 8. The surface may be a high reflectivity means made by aforesaid procedure. And then a white surface is formed as a high reflectivity means. That is, white paint is applied on the surface or the surface is covered with a white sheet. In the thus arranged exposing apparatus, light from an exposure light source 3 is made to be incident onto a surface of a photo/pressure sensitive sheet 7, transmitted through the photo/pressure sensitive sheet 7, and reflected on the mounting surface 8b of the sheet mount 8 at high reflectivity of about 100 % because the mounting surface 8b of the sheet mount 8 is made to have a reflection surface. The thus reflected light is transmitted again through the photo/pressure sensitive sheet 7, so that the photo/pressure sensitive sheet 7 is exposed not only by the directly incident light but by the reflected light. Accordingly, the exposing speed of the photo/pressure sensitive sheet 7 can be made higher.

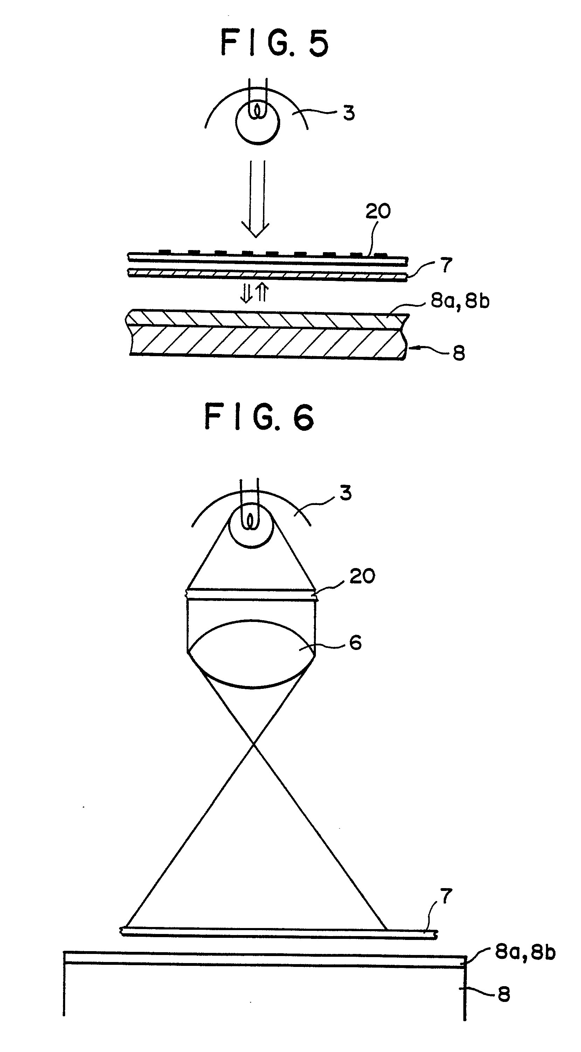

The two above-mentioned embodiments are of a so-called reflection type exposing system in which light from the exposure light source 3 is made to be once incident onto the original 2 and the light reflected on the original 2 is then made to be incident onto the photo/pressure sensitive sheet 7. Additionally, there are a so-called transmission-contact type exposing system and a so-called transmission-focusing type exposing system. In the transmission-contact type exposing system, as illustrated in Fig. 5, an intermediate film 20 (a negative or a positive) is once formed from an original, and exposure is carried out by making the intermediate film 20 closely contact with the photo/pressure sensitive sheet 7. In the transmission focusing type exposing system, as illustrated in Fig. 6, light transmitted through the above-mentioned intermediate film 20 is focused on a photo/pressure sensitive sheet 7 through a focusing lens 6 to thereby carry out exposure. In the transmission contact type exposing system as well as in the transmission-focusing type exposing system, the same effects as those in the foregoing embodiments can be obtained.

As the description is made as to the foregoing embodiments, according to the present invention, the exposure processing is carried out effectively from the upper and lower surface sides of the photo/pressure sensitive sheet, so that a picture can be clearly formed on the photo/pressure sensitive sheet. If the present invention is applied, for example, to a copying machine, a copying speed can be made higher, and energy cost can be reduced by effective use of the quantity of light from the exposure light source with increased economical advantages.

## Claims

1. An exposing apparatus comprising:
a sheet mount for mounting a photo/pressure sensitive sheet thereon for exposing said photo/pressure sensitive sheet;
an exposure light source for exposing said photo/pressure sensitive sheet mounted on said sheet mount from a side opposite to said sheet mount; and

a high reflectivity means provided on a mounting surface of said sheet mount.

2. An exposing apparatus according to Claim 1, in which said high reflectivity means is formed by making a mounting surface of said sheet mount be of a mirror surface.

3. An exposing apparatus according to Claim 1, in which said high reflectivity means is formed by making a mounting surface of said sheet mount be of a metal plated surface.

4. An exposing apparatus according to Claim 1, in which said high reflectivity means is formed of a reflector plate finished to have a mirror surface and attached on said mounting surface.

5. An exposing apparatus according to Claim 2, in which said reflector plate is a metal having a surface polished to be a mirror surface.

6. An exposing apparatus according to Claim 2, in which said reflector plate is a metal plate having a metal-plated surface.

7. An exposing apparatus according to Claim 2, in which said reflector plate is aluminum foil.

8. An exposing apparatus according to Claim 1, in which said high reflectivity means is formed by making a mounting surface of said sheet mount be of a white surface.

9. An exposing apparatus according to Claim 6, in which said white surface is formed by application of white paint onto said mounting surface.

10. An exposing apparatus according to Claim 6, in which said white surface is formed of a white sheet attached on said mounting surface.

# F I G. IA

Incident
light

7

8

# F I G. IB

Incident
light

13

7

14

13

14

# FIG. 2

# FIG. 3

Incident
light

7

⇓⇑

8a

8

# FIG. 4

Incident
light

7

⇓⇑

8b

8

# FIG. 5

# FIG. 6